(19) Europäisches Patentamt
European Patent Office
Office européen des brevets

(11) EP 0 492 565 B1

(12) **EUROPEAN PATENT SPECIFICATION**

(45) Date of publication and mention
of the grant of the patent:
**14.10.1998  Bulletin 1998/42**

(51) Int Cl.[6]: **G06F 17/50**

(21) Application number: **91122079.6**

(22) Date of filing: **21.12.1991**

(54) **Apparatus for calculating geometrical view factor**

Gerät zur Berechnung des geometrischen Sichtfaktors

Appareil pour calculer le facteur de vue geometrique

(84) Designated Contracting States:
**DE FR GB**

(30) Priority: **27.12.1990 JP 416226/90**
**15.03.1991 JP 51000/91**
**15.03.1991 JP 51001/91**

(43) Date of publication of application:
**01.07.1992  Bulletin 1992/27**

(73) Proprietor: **MATSUSHITA ELECTRIC INDUSTRIAL
CO., LTD.
Kadoma-shi, Osaka-fu, 571 (JP)**

(72) Inventors:
• **Hattori, Yoshihiro
  Osaka-shi, Osaka-fu (JP)**
• **Nagamitsu, Sachio Rune-Fujinomori 609
  Fushimi-ku, Kyoto-shi, Kyoto-fu (JP)**
• **Nagata, Yoichi
  Neyagawa-shi, Osaka-fu (JP)**
• **Kodama, Hisashi
  Ikoma-shi, Nara-ken (JP)**

(74) Representative: **Eisenführ, Speiser & Partner
Martinistrasse 24
28195 Bremen (DE)**

(56) References cited:
• **HEWLETT-PACKARD JOURNAL vol. 40, no. 6 ,
December 1989 , PALO ALTO US pages 78 - 88
BURGOON 'global illumination modeling using
radiosity'**
• **APPLIED ENERGY vol. 23, no. 4 , 1986 , GB pages
307 - 313 BABUS'HAQ ET AL 'GEOMETRIC VIEW
FACTORS FOR RADIATION EXCHANGES
BETWEEN AN INFINITELY LONG CYLINDER
AND A PARALLEL INFINITELY LONG
ENCLOSURE OF EITHEIR CYLINDRICAL OR
REGULAR CROSS-SECTION'**

## Description

BACKGROUND OF THE INVENTION

The present invention relates to an apparatus for calculating a geometrical view factor in performing a calculation about radiant heat.

The present invention relates to an apparatus for calculating the geometrical view factor of a rectangular surface required in performing a calculation quickly and accurately about radiation heat in a three-dimensional region.

In recent years, radiant air conditioners, for example, a floor heating apparatus and a panel cooling and heating of a ceiling has been developed. In order to develop this kind of floor heating apparatus, it is necessary to know the magnitude of radiant heat applied to the wall of a room in which the floor heating apparatus is installed. In order to calculate the radiant heat, it is necessary to find a geometrical view factor which depends on the angular or positional relationship between the floor heating apparatus and an object, for example, the wall of the room. As a method for finding the geometrical view factor, energy lines are emitted from a point of the floor heating apparatus to a wall to be radiantly heated and the number of energy lines which have reached the wall are counted.

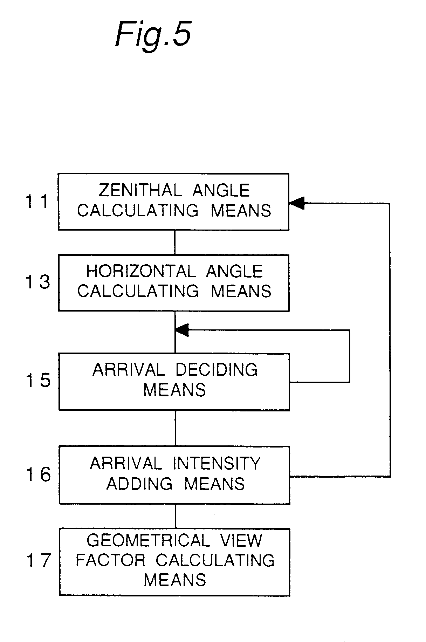

A conventional apparatus for calculating the geometrical view factor is constructed as shown in Fig. 5 and represents the closest prior art from which the invention proceeds. The operation of the apparatus is described below. A hemispherical surface is assumed around the point of the floor heating apparatus. Zenithal angle calculating means 11 generates random numbers in the zenithal angle direction of the spherical surface to find a zenithal angle of the spherical surface. Horizontal angle calculating means 13 generates random numbers in the horizontal angle direction of the spherical surface to find a horizontal angle of the spherical surface. Arrival deciding means 15 decides whether or not an energy line having the decided zenithal angle and horizontal angle reaches a surface of an object. Based on the number of emitted energy lines, arrival intensity adding means 16 calculates the intensities of energy lines at the surface which they have reached. Geometrical view factor calculating means 17 finds the ratio of the intensities of the energy lines at the surface to the intensities of all emitted energy lines to find a geometrical view factor. Refer to a magazine entitled as "Thermal Radiation View Factor Calculation Using Monte Carlo Method, Comparison of Accuracy and Computer Time with Area Integration Method" written by Takeshi IKUSHIMA and et al. and published by Japan Atomic Society, 1988, Vol. 30, No. 6, page 64 - page 70.

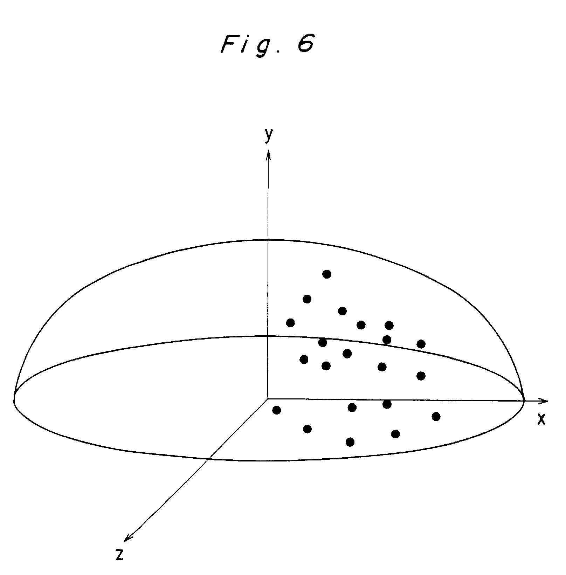

Fig. 6 is an image view showing a method for generating energy lines by utilizing random numbers so as to calculate the number of energy lines which have reached each surface.

However, according to the above-described conventional method, since random numbers are utilized, energy lines emitted from a certain point of an energy source are not necessarily emitted isotropically toward a hemisphere, which means that the number of energy lines cannot be accurately calculated when a small number of energy lines are emitted from the emission point. If many energy lines are emitted therefrom, it takes long to perform a calculation.

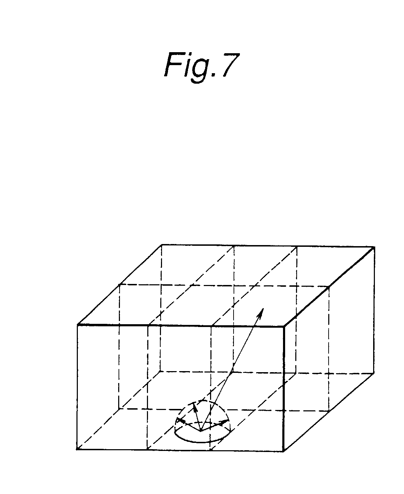

According to the conventional method, a geographical view factor between rectangular surfaces is found as follows: The rectangular surfaces of a three-dimensional region are divided as shown in Fig. 7; energy lines each having an intensity are emitted from a divided rectangular surface of the floor of the region energy source in various directions; the intensity of each energy line which has reached an object rectangular surface of a solid wall of the region is calculated; and the ratio of the intensities of energy lines which have reached the object rectangular surface of the solid wall to the intensity obtained by adding the intensities of all energy lines emitted from the divided rectangular surface is found and then the geometrical view factor between the divided rectangular surface of the floor and the object rectangular surface of the solid wall is founded (Papers of lectures given at meeting of Air Conditioning Sanitary Engineering Society, 1990, page 1161 through 1164 N. Takeya et al.: "Study about numerical estimate of airflow and thermal distribution in room"). Supposing that the emitted energy lines reach the object rectangular surface of the solid wall directly, arrival positions of energy lines are calculated.

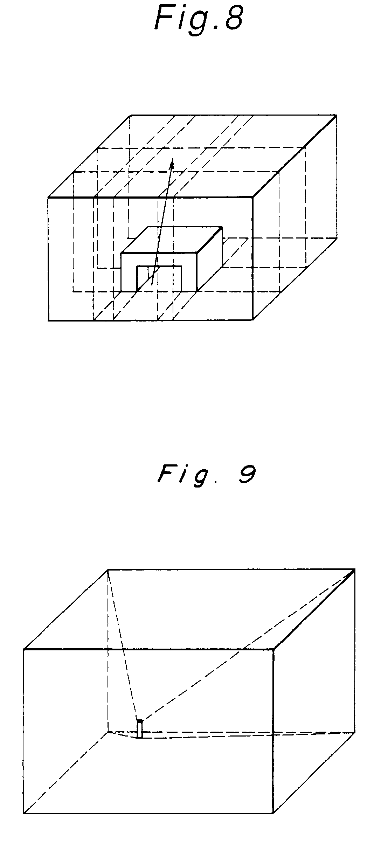

However, according to the above conventional method, in a space such as a room accommodating a furniture or a furnishing as shown in Fig. 8, an accurate geographical view factor cannot be obtained because it is assumed that the emitted energy lines directly reach the surface of the solid wall and then the existence of the furniture is not considered. In analyzing hot air flow in the room, the space is divided with fine mesh.

In order to quickly trace an energy line in the space which is regarded as not absorbing radiation heat, it is necessary to regenerate meshes by an element which constitutes a solid body which absorbs radiant heat.

When the transmission of radiant heat from air conditioning equipments such as a floor heating equipment, a panel cooling and heating of a ceiling, or the like is calculated, it is necessary to find a geographical view factor which is determined according to an angle and a position. Specially, it is necessary to find a geographical view factor between a human body and a rectangular surface in order to calculate the transmission of radiant heat between the human body and a radiant wall. In such calculations, a model is considered as the human body in order to perform the calculations. Conventionally, the human body is regarded as a microelement to find the geographical view factor between the micro-cylinder and the rectangular surface as shown in Fig. 9.

This method is described in a magazine of "Ann. Physiological Anthrop." published in 1988, in 7(3), on pages 143 through 150: T. Horikoshi et.al.: "Configuration Factors between Cylindrical Element as a Model of the Human Body and a Rectangular Plane". In order to find the geographical view factor, an area integration equation is used by finely dividing the cylindrical surface and the rectangular surface.

However, according to the conventional art, it takes a long period of time for calculations to be performed because cylindrical and rectangular surfaces must be finely divided. In addition, it is necessary to limit an integration range if another rectangular surface is interposed between the cylindrical surface and the rectangular surface. Thus, accurate calculations cannot be performed. Further, in performing calculation, attention is not paid to the actual dimensions of the human body. Therefore, the influence of radiant heat from the rectangular surface to the human body is not correctly calculated.

SUMMARY OF THE INVENTION

It is an object of the present invention to provide an apparatus for calculating a thermal radiant geometrical view factor accurately and quickly.

It is an object of the present invention to provide an apparatus for tracing emitted energy lines accurately and quickly.

In accomplishing these and other objects, according to the present invention, there is provided an apparatus for calculating a geometrical view factor for radiant heat determination between an object surface and a rectangular surface serving as a bottom surface of a spherical surface assumed on the rectangular surface when energy lines are emitted from a center of the bottom surface of the spherical surface on the rectangular surface to the object surface, comprising:

first calculating means for calculating a zenithal angle of each energy line by dividing the spherical surface in a zenithal angle direction at equal intervals; second calculating means for calculating a dividing number of horizontal angles corresponding to the zenithal angle calculated by the first calculating means; third calculating means for calculating a divided horizontal angle by dividing an entire horizontal angle of the spherical surface into the dividing number of horizontal angles determined by the second calculating means; fourth calculating means for calculating an intensity corresponding to the zenithal angle determined by the third calculating means; input means for inputting a coordinate of a configuration of an obstruction for preventing the emitted energy line from reaching the object surface; deciding means for deciding whether or not the energy lines emitted from the center of the bottom surface the spherical surface at the intensity calculated by the fourth calculating means reach the object surface while the energy lines pass through a point on the spherical surface corresponding to the zenithal angle and the horizontal angle determined by the first and third calculating means, based on the coordinated of the obstruction inputted by the inputting means; adding means for adding to each other the intensities of the energy lines which have reached each object surface based on a decision made by the deciding means; and means for calculating the geometrical view factor by dividing by the intensity of the entire energy lines the intensity of each object surface obtained by the addition performed by the adding means.

According to such apparatus, the zenithal angle of a spherical surface is divided at regular intervals, the horizontal angle thereof is also divided at regular intervals in correspondence with each of the zenithal angles, and in addition, the intensity of each emitted energy line corresponds to each zenithal angle. Thus, the energy lines can be isotropically emitted from the center of the bottom surface of the spherical surface. The emitted energy lines are traced from the emission point to each object surface and the intensity of each energy line which has reached each object surface are added to each other. Then, the intensity obtained by the addition is divided by the intensity of entire energy lines emitted from the emission point. Thus, the geometrical view factor of each surface can be found quickly and accurately.

BRIEF DESCRIPTION OF THE DRAWINGS

These and other objects and features of the present invention will become apparent from the following description taken in conjunction with the preferred embodiments thereof with reference to the accompanying drawings, in which:

Fig. 1 is a perspective view showing an indoor space to find a geometrical view factor according to a preferred embodiment of the present invention;
Fig. 2 is a block diagram showing the construction of an apparatus for calculating a geometrical view factor;
Fig. 3A is a schematically perspective view showing the operation for dividing the hemispherical surface in the apparatus of Fig. 2:
Fig. 3B is a schematically perspective view showing the operation for emitting energy lines in the apparatus of Fig. 2;
Fig. 4 is a flowchart showing the operation of the preferred embodiment;
Fig. 5 is a block diagram showing the construction of a conventional apparatus for calculating a geometrical view factor;
Fig. 6 is a schematically perspective view snowing the content of the conventional apparatus for calculating a geometrical view factor;
Fig. 7 is an illustration showing energy line tracing to be carried out by a conventional apparatus for calculating a geometrical view factor;
Fig. 8 is an illustration showing an energy line tracing to be carried out by the conventional apparatus when there is a furniture in a space; and
Fig. 9 is a model view in which a human body is supposed as a microcylinder in a conventional apparatus for calculating a geographical view factor.

DETAILED DESCRIPTION OF THE INVENTION

Before the description of the present invention proceeds, it is to be noted that like parts are designated by like reference numerals throughout the accompanying drawings.

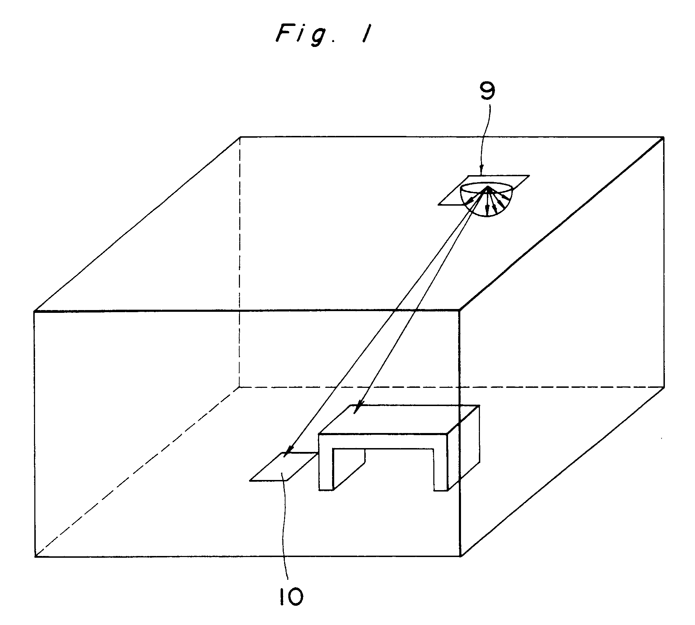

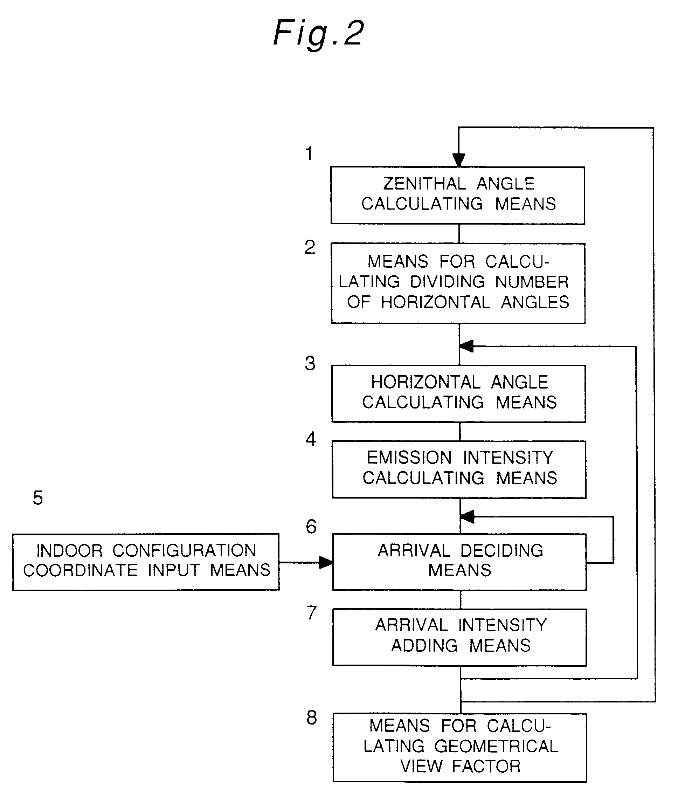

Fig. 1 is a perspective view showing an indoor space provided to find a geometrical view factor according to an embodiment of the present invention. In this embodiment, an energy source 9 such as a heat source or a light source is provided on the ceiling so that what percentage the energy generated by the energy source reaches a divided object rectangular surface of the floor, namely, the geometrical view factor between the energy source and the object area is calculated. A hemispherical surface is assumed around the emission point of the energy source 9. Fig. 2 is a block diagram showing the construction of an apparatus for calculating the geometrical view factor. The apparatus comprises zenithal angle calculating means 1, means 2 for calculating dividing number of horizontal angle, horizontal angle calculating means 3, emission intensity calculating means 4, indoor configuration coordinate input means 5, arrival deciding means 6, arrival intensity adding means 7, and means 8 for calculating geometrical view factor.

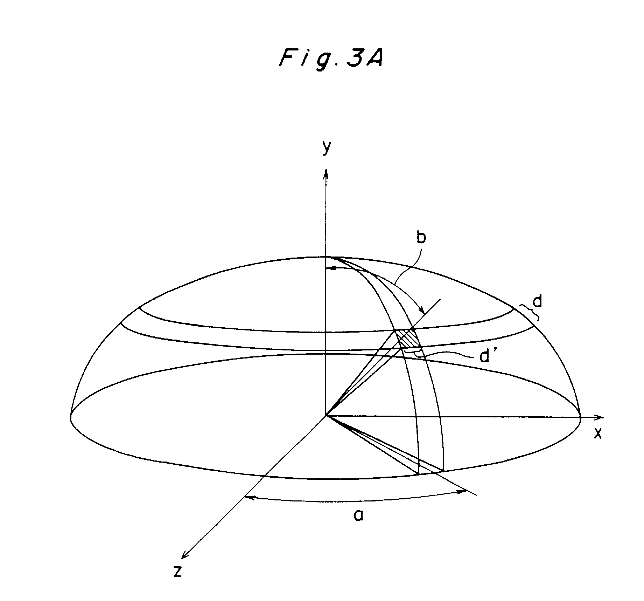

The zenithal angle calculating means 1 determines a zenithal angle of the hemispherical surface by dividing the hemispherical surface in its zenithal angle direction at equal intervals. The horizontal angle calculating means 2 calculates the dividing number of the horizontal angle of the hemispherical surface corresponding to the zenithal angle determined by the zenithal angle calculating means 1. The horizontal angle calculating means 3 calculates the horizontal angle by dividing the horizontal angle into the dividing number of the horizontal angle determined by the horizontal angle calculating means 2. The emission intensity calculating means 4 calculates an intensity corresponding to the zenithal angle determined by the horizontal angle calculating means 3. The indoor configuration coordinate input means 5 inputs the coordinate of the configuration of a room including the position of a furniture such as a desk or furnishings. The deciding means 6 decides whether or not an energy line emitted from the center of the bottom surface the hemispherical surface at the above intensity reaches an object surface corresponding to the zenithal angle and the horizontal angle determined by the zenithal angle calculating means 1 and the horizontal angle calculating means 3, respectively. The intensity adding means 7 adds to each other the intensities of energy lines which have reached each object rectangular surface based on the result obtained by the decision made by the input means 5. The geometrical view factor calculating means 8 calculates a geometrical view factor based on the intensity obtained by the addition performed by the deciding means 6. As shown in Fig. 3A, the zenithal angle (b) is an angle which a perpendicular drawn from an emission point to the hemispherical surface forms with y-axis, and the horizontal angle (a) is an angle which a line emitted from the emission point to a given point on the hemispherical surface forms with z-axis.

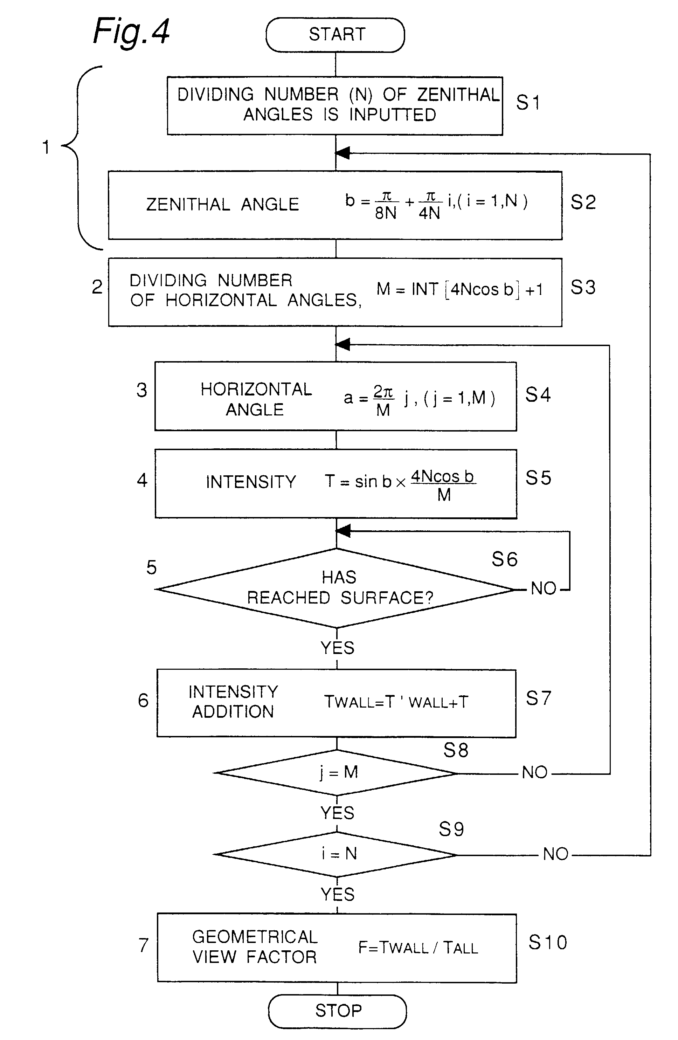

Fig. 4 is a flowchart showing the operation of the apparatus. First, at step S1, the dividing number (N) of the zenithal angle is inputted. At step S2, the zenithal angle (b) is found by the following equation (1) supposing that (i) is an integer in the range from 1 to N:

$$b = \pi/(8N) + \pi/(4N) * i \qquad (1)$$

At step S3, the dividing number (M) of the horizontal angle (a) is found by the following equation (2) as an integer corresponding to the zenithal angle (b):

$$M = INT [4Ncosb] \qquad (2)$$

At step S4, based on the dividing number (M) of the horizontal angle (a), the horizontal angle (a) is found from the following equation (3) supposing that (j) is an integer in the range from 1 to M:

$$a = 2\pi/M * j \qquad (3)$$

The above calculation is described in terms of the length of a dividing line with reference to Fig. 3A. If the zenithal angle (b) is found, the length (d) of the dividing line in the zenithal angle direction is determined. Then, in order to approximate a length (d') in the horizontal direction to the length (d), the circumference in the horizontal direction formed by connecting points on the hemispherical surface which forms the zenithal angle (b) is divided by the length (d). It is assumed that the quotient is (M). If the length (d) does not exactly divide the circumference, the circumference in the horizontal direction is divided by (M+1), with the circumference (M+1) set as a dividing number in the horizontal direction. Consequently, the quotient (d') is obtained. Alternately, the following method may be performed: If the remainder of the division of the circumference by the length (d) is 0.5 or more, the dividing number is set as (M+1). If the remainder of the division of the circumference by the length (d) is less than 0.5, the dividing number is set as (M). Thus, the length (d') of a line in the horizontal direction dividing the circumference can be found. Thus, the horizontal angle (a) is determined.

At step S5, considering the Lambert's cosine law and that the number of energy lines which have reached each hemispherical surface is expressed as an integer, the intensity (T) of the entire energy lines is corrected by the following equation (4):

$$T = \sin b * 4N\cos b/M \qquad (4)$$

where M is the dividing number in the horizontal direction actually used.

At step S6, based on the horizontal angle (a), the zenithal angle (b), and the coordinate of the indoor configuration, the three-dimensional coordinate of each energy line is geometrically traced until each energy line reaches the object surface of a solid body. When each energy line has reached the object surface of the solid body, it is decided where the energy line has reached, for example, part of the floor surface, the surface of table, or the like. Then, the intensities (T) of the energy lines which have reached each surface are added to each other based on the following equation (5) at step S7.

$$T_{WALL} = T'_{WALL} + T \qquad (5)$$

In the equation (5), when the intensity (T) of the energy line is firstly found, the value ($T'_{WALL}$) is zero and then in the equation (5), $T_{WALL} = T$. Then, when the intensity (T) of the energy line is secondly found, the firstly found intensity value ($T_{WALL}$) is substituted in the equation (5) as a value ($T'_{WALL}$) and then the firstly found intensity ($T'_{WALL}$) and the now found intensity (T) are added to each other to find the new intensity ($T_{WALL}$).

Then, at step S8, (j) is increased by "1" and then the horizontal angle (a) is changed to carry out the operations of steps S4 through S7 again. At step S9, after (j) takes the value "1" through (M) at step S8, (i) is increased by "1" and then the zenithal angle (b) is changed to perform the operation of steps S2 through S8. At step S10, after (i) takes the value "1" through (N) at step S9, the intensity ($T_{WALL}$) of each surface obtained by the addition is divided by the entire intensity ($T_{ALL}$) of the emission hemispherical surface so as to find a geometrical view factor (F) from the following equation (6):

$$F = T_{WALL}/T_{ALL} \qquad (6)$$

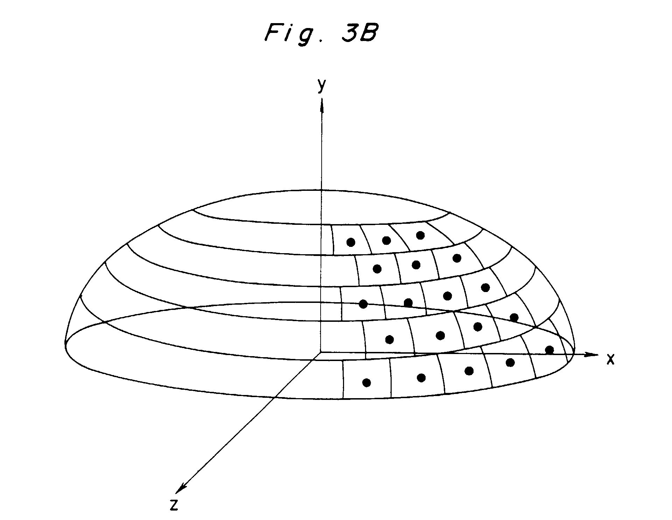

Fig. 3B is an image view showing the content of the above-described embodiment of the present invention. As shown in Fig. 3B, energy lines are emitted uniformly.

Unlike the above embodiment in which the energy source is provided on the ceiling in Fig. 1, the emission point of energy lines is provided on the floor surface in order to find the transmission of heat generated by a floor heating apparatus. To this end, energy lines are emitted from the center of the bottom surface a hemisphere to the hemispherical surface as shown in Fig. 3B. The geometrical view factor can be found based on the intensities of energy lines at each surface which the energy line has reached. In addition, the transmission of heat generated by a radiant panel can be found. That is, energy lines are emitted from a given point of the surface of the panel to a hemisphere with the emission point set as the center of the bottom surface the hemisphere. Similarly to the above-described floor heating apparatus, the geometrical view factor can be found.

The above-described means of the present invention may be carried out by software by using a computer, but may be performed by a specialized hardware circuit having each function.

According to the present invention, the geometrical view factor of a cylinder or a human body and a rectangular surface can be precisely and quickly calculated. Thus, the transmission of radiant heat can be accurately and quickly calculate.

## Claims

1. An apparatus for calculating a geometrical view factor for radiant heat between an object surface and a rectangular surface serving as a bottom surface of a spherical surface assumed on the rectangular surface when energy lines are emitted from a center of the bottom surface of the spherical surface on the rectangular surface to the object surface, comprising:

   first calculating means (1) for calculating a zenithal angle (b) of each energy line;
   third calculating means (3) for calculating a divided horizontal angle (a);
   deciding means (6) for deciding whether or not the energy lines emited reach the object surface;
   adding means (7) for adding to each other the intensities (T) of the energy lines which have reached each object surface based on a decision made by the deciding means (6); and
   means (8) for calculating the geometrical view factor by dividing by the intensity (T) of the entire energy lines the intensity ($T_{WALL}$) of each object surface obtained by the addition performed by the adding means (7);

   characterized in that

said first calculating means (1) is provided for calculating said zenithal angle (b) of each energy line by dividing the spherical surface in a zenithal angle direction at equal intervals;

a second calculating means (2) is provided for calculating a dividing number (M) of horizontal angles (a) corresponding to the zenithal angle calculated by the first calculating means (1);

said third calculating means (3) is provided for calculating said divided horizontal angle by dividing an entire horizontal angle of the spherical surface into the dividing number (M) of horizontal angles (a) determined by the second calculating means (2);

a fourth calculating means (4) is provided for calculating an intensity (T) corresponding to the zenithal angle (b) determined by the third calculating means (3);

an input means (5) is provided for inputting a coordinate of a configuration of an obstruction for preventing the emitted energy line from reaching the object surface; and

said deciding means (6) is provided for deciding whether or not the energy lines emitted from the center of the bottom surface of the spherical surface at the intensity (T) calculated by the fourth calculating means (4) reach the object surface while the energy lines pass through a point on the spherical surface corresponding to the zenithal angle (b) and the horizontal angle (a) determined by the first and third calculating means (1, 3), based on the coordinate of the obstruction inputted by the inputting means (5).

2. The apparatus for calculating a geometrical view factor as defined in claim 1, wherein the spherical surface is a hemispherical surface.

**Patentansprüche**

1. Gerät zur Berechnung eines geometrischen Sichtfaktors für die Bestimmung von Strahlungswärme zwischen einer Oberfläche eines Objektes und einer rechtwinkligen Fläche, die als Bodenfläche einer sphärischen Fläche dient, welche auf der rechtwinkligen Fläche vermutet wird, wenn Energielinien von einem Mittelpunkt der Bodenfläche der sphärischen Fläche auf der rechtwinkligen Fläche auf die Oberfläche des Objektes abgestrahlt werden, mit:

einer ersten Berechnungseinrichtung (1) zur Berechnung eines Zenithwinkels (b) jeder Energielinie;

einer dritten Berechnungseinrichtung (3) zur Berechnung eines unterteilten horizontalen Winkels (a);

einer Ermittlungseinrichtung (6) zur Ermittlung, ob die ausgestrahlten Energielinien die Oberfläche des Objektes erreichen oder nicht;

einer Addiereinrichtung (7) zur Addition der Intensitäten (T) der Energielinien zueinander, die jede Oberfläche des Objektes erreicht haben, und zwar auf der Grundlage einer von der Ermittlungseinrichtung (6) getroffenen Ermittlung; und

einer Einrichtung (8) zur Berechnung des geometrischen Sichtfaktors, indem die Intensität ($T_{WALL}$) jeder Oberfläche des Objektes, die man durch die durch die Additionseinrichtung (7) durchgeführte Addition erhält, durch die Intensität (T) der gesamten Energielinien geteilt wird;

dadurch gekennzeichnet, daß

die erste Berechnungseinrichtung (1) zur Berechnung des Zenithwinkels (b) jeder Energielinie durch Unterteilung der sphärischen Fläche in einer Richtung des Zenithwinkels in gleiche Intervalle vorgesehen ist;

eine zweite Berechnungseinrichtung (2) zur Berechnung einer Teilungszahl (M) der horizontalen Winkel (a) entsprechend dem von der ersten Berechnungseinrichtung (1) berechneten Zenithwinkel vorgesehen ist;

die dritte Berechnungseinrichtung (3) zur Berechnung des unterteilten horizontalen Winkels durch Unterteilung eines gesamten horizontalen Winkels der sphärischen Fläche in die Teilungszahl (M) der von der zweiten Berechnungseinrichtung (2) festgestellten horizontalen Winkel (a) vorgesehen ist,

eine vierte Berechnungseinrichtung (4) zur Berechnung einer Intensität (T) entsprechend dem von der dritten Berechnungseinrichtung (3) ermittelten Zenithwinkel vorgesehen ist;

eine Eingabeeinrichtung (5) zur Eingabe einer Koordinate einer Konfiguration eines Hindernis, das die abgestrahlte Energielinie daran hindert, die Oberfläche des Objektes zu erreichen, vorgesehen ist; und

die Ermittlungserinrichtung (6) vorgesehen ist, um zu ermitteln, ob die Energielinien, die vom Mittelpunkt der Bodenfläche der sphärischen Fläche mit der von der vierten Berechnungseinrichtung (4) berechneten Intensität (T) abgestrahlt werden, die Oberfläche des Objektes erreichen, während die Energielinien durch einen Punkt auf der sphärischen Fläche entsprechend dem Zenithwinkel (b) und dem Horizontalwinkel (a), welche von den ersten und dritten Berechnungseinrichtungen (1, 3) ermittelt sind, laufen, und zwar auf der Grundlage der durch die Eingabeeinrichtung (5) eingegebenen Koordinate des Hindernisses.

**2.** Gerät zur Berechnung eines geometrischen Sichtfaktors nach Anspruch 1, bei welchem die sphärische Fläche eine hemisphärische Fläche ist.

## Revendications

**1.** Appareil pour calculer un facteur de vue géométrique pour la détermination de chaleur rayonnée, entre une surface d'un objet et une surface rectangulaire servant de surface de fond à une surface sphérique considérée comme étant sur la surface rectangulaire, quand les lignes d'énergie partent du centre de la surface de base de la surface sphérique sur la surface rectangulaire, vers la surface de l'objet, comprenant :

un premier moyen de calcul (1), pour calculer un angle zénithal (b) de chaque ligne d'énergie;
un troisième moyen de calcul (3) pour calculer un angle horizontal divisé (a);
un moyen de décision (6) pour décider si les lignes d'énergie émise atteignent ou non la surface de l'objet;
un moyen d'addition (7) pour ajouter ensemble les intensités (T) des lignes d'énergie qui ont atteint chaque surface de l'objet, sur la base d'une décision faite par le moyen de décision (6); et
un moyen (8) pour calculer le facteur de vue géométrique en divisant par l'intensité (T) de l'ensemble des lignes d'énergie, l'intensité ($T_{PAROI}$) de chaque surface de l'objet obtenue par l'addition effectuée par le moyen d'addition (7);

caractérisé en ce que :

ledit premier moyen de calcul (1) est prévu pour calculer ledit angle zénithal (b) de chaque ligne d'énergie en divisant la surface sphérique dans une direction d'angle zénithal, à des intervalles réguliers;
un second moyen de calcul (2) est prévu pour calculer un nombre divisé (M) d'angles horizontaux (a) correspondant à l'angle zénithal calculé par le premier moyen de calcul (1);
ledit troisième moyen de calcul (3) est prévu pour calculer ledit angle horizontal divisé, en divisant un angle horizontal entier de la surface sphérique en un nombre divisé (M) d'angles horizontaux (a), déterminé par le second moyen de calcul (2);
un quatrième moyen de calcul (4) est prévu pour calculer une intensité (T) correspondant à l'angle zénithal (b) déterminé par le troisième moyen de calcul (3);
un moyen d'entrée (5) de données est prévu pour entrer une coordonnée d'une configuration d'une obstruction empêchant les lignes d'énergie émise d'atteindre la surface de l'objet; et
ledit moyen de décision (6) est prévu pour décider si les lignes de l'énergie émise depuis le centre de la surface de fond de la surface sphérique avec l'intensité (T) calculée par le quatrième moyen de calcul (4) atteignent ou non la surface de l'objet, alors que les lignes d'énergie passent par un point sur la surface sphérique correspondant à l'angle zénithal (b) et à l'angle horizontal (a) déterminés par le premier et le troisième moyens de calcul (1, 3) sur la base de la coordonnée de l'obstruction entrée par le moyen d'entrée (5) des données.

**2.** Appareil pour calculer le facteur de vue géométrique, comme défini dans la revendication 1, où la surface sphérique est une surface hémisphérique.

# Fig. 1

# Fig.2

```
1 ┌─────────────────────────┐
  │   ZENITHAL  ANGLE        │
  │   CALCULATING  MEANS     │
  └─────────────────────────┘

2 ┌─────────────────────────┐
  │   MEANS  FOR  CALCU-     │
  │   LATING DIVIDING NUMBER │
  │   OF HORIZONTAL ANGLES   │
  └─────────────────────────┘

3 ┌─────────────────────────┐
  │   HORIZONTAL  ANGLE      │
  │   CALCULATING  MEANS     │
  └─────────────────────────┘

4 ┌─────────────────────────┐
  │   EMISSION  INTENSITY    │
  │   CALCULATING  MEANS     │
  └─────────────────────────┘

5

  ┌──────────────────────────┐    6 ┌─────────────────────────┐
  │ INDOOR CONFIGURATION     │─────▶│   ARRIVAL  DECIDING      │
  │ COORDINATE INPUT MEANS   │      │   MEANS                  │
  └──────────────────────────┘      └─────────────────────────┘

7 ┌─────────────────────────┐
  │   ARRIVAL  INTENSITY     │
  │   ADDING  MEANS          │
  └─────────────────────────┘

8 ┌─────────────────────────┐
  │   MEANS  FOR  CALCU-     │
  │   LATING GEOMETRICAL     │
  │   VIEW  FACTOR           │
  └─────────────────────────┘
```

Fig. 3A

Fig. 3B

## Fig.4

START

1 {

DIVIDING NUMBER (N) OF ZENITHAL ANGLES IS INPUTTED — S1

ZENITHAL ANGLE $\quad b = \dfrac{\pi}{8N} + \dfrac{\pi}{4N} i, ( i = 1, N )$ — S2

}

2 — DIVIDING NUMBER OF HORIZONTAL ANGLES, $\quad M = INT \left[ 4N\cos b \right] + 1$ — S3

3 — HORIZONTAL ANGLE $\quad a = \dfrac{2\pi}{M} j , ( j = 1, M )$ — S4

4 — INTENSITY $\quad T = \sin b \times \dfrac{4N\cos b}{M}$ — S5

5 — HAS REACHED SURFACE? — S6 — NO

YES

6 — INTENSITY ADDITION $\quad T_{WALL} = T'_{WALL} + T$ — S7

$j = M$ — S8 — NO

YES

$i = N$ — S9 — NO

YES

7 — GEOMETRICAL VIEW FACTOR $\quad F = T_{WALL} / T_{ALL}$ — S10

STOP

# Fig.5

```
      ┌─────────────────────────┐
      │   ZENITHAL  ANGLE       │ ◄──────────┐
 1 1  │  CALCULATING  MEANS     │            │
      └─────────────────────────┘            │
                  │                          │
      ┌─────────────────────────┐            │
      │   HORIZONTAL  ANGLE     │            │
 1 3  │  CALCULATING  MEANS     │            │
      └─────────────────────────┘            │
                  │ ◄──────────────┐         │
      ┌─────────────────────────┐  │         │
      │   ARRIVAL  DECIDING     │  │         │
 1 5  │        MEANS            │──┘         │
      └─────────────────────────┘            │
                  │                          │
      ┌─────────────────────────┐            │
      │   ARRIVAL  INTENSITY    │            │
 1 6  │     ADDING  MEANS       │────────────┘
      └─────────────────────────┘
                  │
      ┌─────────────────────────┐
      │  GEOMETRICAL  VIEW      │
 1 7  │ FACTOR  CALCULATING     │
      │        MEANS            │
      └─────────────────────────┘
```

Fig. 6

Fig.7

## Fig.8

## Fig. 9